# EUROPEAN PATENT APPLICATION

(11) **EP 4 072 010 A1**
(43) Date of publication of application: **12.10.2022**
(21) Application number: 21305443.0
(22) Date of filing: 07.04.2021
(51) Int. Cl.: H03F 1/02, H03F 3/21, H02M 7/42

(54) **A LINEAR AMPLIFIER FOR PROVIDING A SINUSOIDAL WAVEFORM TO A LOAD**

(71) Applicant: Mitsubishi Electric R & D Centre Europe B.V., 1119 NS Schiphol Rijk (NL); Mitsubishi Electric Corporation, Tokyo 100-8310 (JP)
(72) Inventor: REGNAT, Guillaume, 35708 RENNES Cedex 7 (FR); PERRIN, Rémi, 35708 RENNES Cedex 7 (FR); LEFEVRE, Guillaume, 35708 RENNES Cedex 7 (FR)
(74) Representative: Cabinet Le Guen Maillet

(57) **Abstract**

The present invention concerns a linear amplifier for providing a sinusoidal waveform to a load, characterised in that the linear amplifier is composed of an asymmetric amplifier and a H-bridge module, the asymmetric amplifier comprises at least one transistor that amplifies a full wave rectified sinus signal that is transformed by the H bridge module into a sinewave signal that is provided to the load.

## Description

### TECHNICAL FIELD

The present invention relates generally to a linear amplifier for providing a sinusoidal waveform to a load.

### RELATED ART

Linear mode application is commonly used for power as well as radiofrequency applications for the amplification of sinusoidal signals or for direct current control.

In power electronics applications, the linear mode is used for fan application or battery charging where a power semiconductor is used as a current source directly controlled through its gate.

On the other hand, the so-called "class-A" or "class-B" linear amplifier essentially produces a continuous sinusoidal voltage and/or current, while a pulse width modulation (PWM) inverter applies a discrete voltage-pulse train to the load.

The linear amplifier goes along a significant amount of power losses, because the semiconductor devices always work in linear amplification state (thus the transistor is crossed by a current and a voltage). Therefore, the efficiency which is around 78.5% of the linear amplifier (which is around 78.5%) is rather low, that even the conventional class-B amplifier.

The Class B or "Push-Pull" linear power amplifier is using complementary pair of switch P and N in order to produce a symmetrical sinusoidal waveform.

Different kinds of improvement have been published for dealing with the low efficiency of this basic class B cell, like for example by multiplying the number of stages in order to reduce the constraints on each switch stage. The improvement consisting in increasing the number of stages remains capped by the cost and the complexity of the circuit.

As explained in the above paragraph, for high efficiency amplifier, a high number of stages is needed, which means a high number of P and N semiconductors as well as high complexity of the circuit. In terms of manufacturing, P semiconductors are not as largely used as the N type which means the availability for P type semiconductors is more difficult and with less variety.

### SUMMARY OF THE INVENTION

The present invention aims to propose a new topology of circuit with only N-type semiconductors with a reduced number of components and a higher efficiency.

To that end, the present invention concerns a linear amplifier for providing a sinusoidal waveform to a load, characterised in that the linear amplifier is composed of an asymmetric amplifier and a H-bridge module, the asymmetric amplifier comprises at least one transistor that amplifies a full wave rectified sinus signal that is transformed by the H bridge module into a sinewave signal that is provided to the load.

Thus, only semiconductors of the same type may be used, the number of components is reduced and a higher efficiency is obtained.

According to a particular feature, the asymmetric amplifier comprises plural transistors of the same type, and the same full wave rectified sinus signal is provided to each transistor.

Thus, the efficiency of the linear amplifier is improved.

According to a particular feature, the transistors are N type semiconductors.

Thus, the choice of semiconductors is improved and the cost of the linear amplifier is reduced.

According to a particular feature, each transistor is in a OFF state or in a linear amplification state or in a ON state and only one transistor among the plural transistors is in the linear amplification state during at least one period of time of the period of the full rectified wave signal.

Thus, the duration of the linear amplification state of the transistors is reduced, less stress is then supported by the transistors.

According to a particular feature, the asymmetric amplifier comprises the same number of DC voltage sources as the number of transistors.

Thus, the duration of the linear amplification state of the transistors may be controlled easily.

According to a particular feature, each voltage source provides the same voltage value.

Thus, the semiconductors have the same breakdown voltage, leading to easy semiconductor choice and cost reduction for mass production of the asymmetric linear amplifier.

Thus, the semiconductors have the same breakdown voltage, leading to easy semiconductor choice and cost reduction for mass production of the asymmetric linear amplifier.

### BRIEF DESCRIPTION OF THE DRAWINGS

The characteristics of the invention will emerge more clearly from a reading of the following description of example embodiments, the said description being produced with reference to the accompanying drawings, among which:
Fig. 1 represents an example of architecture of linear amplifier according to the present invention;
Fig. 2 represents chronograms of the different operation modes of the power semiconductors of the asymmetric linear amplifier;
Fig. 3 represents the different waveforms of signals of the asymmetric linear amplifier according to the present invention;
Fig. 4 represents the waveforms for controlling the semiconductors of the H bridge module of the linear amplifier.

### DESCRIPTION

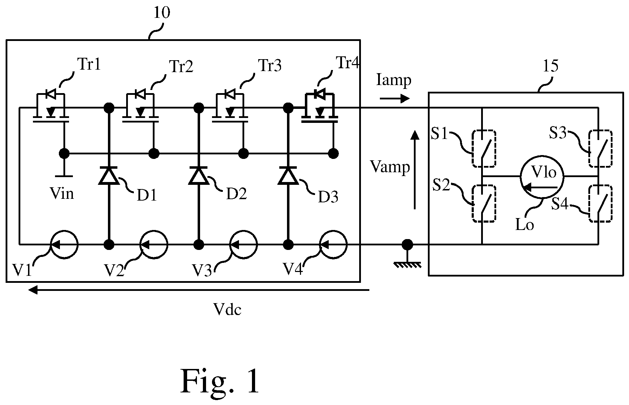

**Fig. 1** represents an example of architecture of linear amplifier according to the present invention.

The linear amplifier is, according to the present invention, composed of an asymmetric linear amplifier 10 and a H-bridge module 15.

The asymmetric linear amplifier 10 is composed of at least one transistor the gate of which is driven by a positive full wave rectified sinus signal. In the example of Fig. 1, the asymmetric linear amplifier 10 comprises for transistors Tr1, Tr2, Tr3 and T4, three diodes D1, D2 and D3 and four DC voltage sources V1, V2, V3 and V4.

Less or more transistors may be used in the asymmetric linear amplifier.

The transistors are for example N type MOSFET transistors.

The same signal Vin applied to each gate of the transistors Tr1 to Tr4 is a positive full wave rectified sinus signal.

The drain of the transistor Tr1 is connected to a first terminal of the DC voltage source V1.

The source of the transistor Tr1 is connected to a cathode of the diode D1, the anode of which is connected to a second terminal of the DC voltage source V1 and to a first terminal of the DC voltage source V2.

The voltage between the second terminal of the DC voltage source V1 and the first terminal of the DC voltage source V1 is positive.

The drain of the transistor Tr2 is connected to the source of the transistor Tr1 and to the cathode of the diode D1.

The source of the transistor Tr2 is connected to a cathode of the diode D2, the anode of which is connected to a second terminal of the DC voltage source V2 and to a first terminal of the DC voltage source V3.

The voltage between the second terminal of the DC voltage source V2 and the first terminal of the DC voltage source V2 is positive.

The drain of the transistor Tr3 is connected to the source of the transistor Tr2 and to the cathode of the diode D2.

The source of the transistor Tr3 is connected to a cathode of the diode D3, the anode of which is connected to a second terminal of the DC voltage source V3 and to a first terminal of the DC voltage source V4.

The voltage between the second terminal of the DC voltage source V3 and the first terminal of the DC voltage source V3 is positive.

The drain of the transistor Tr4 is connected to the source of the transistor T3 and to the cathode of the diode D3.

The source of the transistor Tr4 is connected to a first terminal of the H-bridge module 15.

The second terminal of the DC voltage source V4 is connected to a second terminal of the H-bridge module 15 and to the ground.

The voltage between the second terminal of the DC voltage source V4 and the first terminal of the DC voltage source V3 is positive.

Preferably, the voltage provided by each DC voltage source V1 to V4 is identical and equal to Vdc/4, where Vdc is for example equal to 300 Volts.

In a variant, the voltage provided by each DC voltage source V1 to V4 is different.

The H bridge module 15 is composed of fourth switches S1, S2, S3 and S4.

A first terminal of the switch S1 is connected to the first terminal of the H bridge module 15, a first terminal of the switch S3 is connected to the first terminal of the H bridge module 15.

A second terminal of the switch S1 is connected to a first terminal of the switch S2 and to a first terminal of the load Lo. A second terminal of the switch S3 is connected to a first terminal of the switch S4 and to a second terminal of the load Lo.

The second terminal of the switch S2 is connected to the second terminal of the H bridge module 15. The second terminal of the switch S4 is connected to the second terminal of the H bridge module 15.

The load Lo is for example a power grid and the linear amplifier provides a sinewave current to the power grid by providing a full wave rectified sinus current lamp that is unfolded by the H bridge module in order to provide the sinewave current to the power grid.

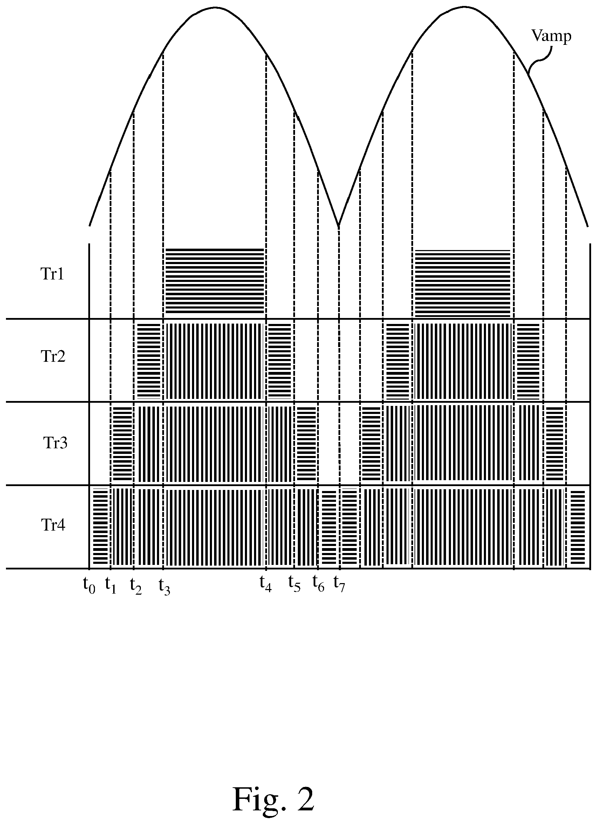

**Fig. 2** represents chronograms of the different operation modes of the power semiconductors of the asymmetric linear amplifier.

The voltage Vamp is the voltage between the first and second terminals of the H bridge module 15.

The transistors Tr1 to Tr4 are in a OFF state or in ON state or in a linear amplification state.

The linear amplification state is represented in Fig. 2 by an area of horizontal lines, the ON state is represented by an area of vertical lines.

Between times to and t₁, the transistor Tr4 is in the linear amplification state and the transistors Tr1 to Tr3 are in the OFF state.

Between times t₁ and t₂, the transistor Tr4 is in the ON state, the transistor Tr3 is in the linear amplification state and the transistors Tr2 and Tr1 are in the OFF state.

Between times t₂ and t₃, the transistors Tr3 and Tr4 are in the ON state, the transistor Tr2 is in the linear amplification state and the transistor Tr1 is in the OFF state.

Between times t₃ and t₄, the transistors Tr2, Tr3 and Tr4 are in the ON state and the transistor Tr1 is in the linear amplification state.

Between times t₄ and t₅, the transistors Tr3 and Tr4 are in the ON state, the transistor Tr2 is in the linear amplification state and the transistor Tr1 is in the OFF state.

Between times t₅ and t₆, the transistor Tr4 is in the ON state, the transistor Tr3 is in the linear amplification state and the transistors Tr2 and Tr1 are in the OFF state.

Between times t₆ and t₇, the transistor Tr4 is in the linear amplification state and the transistors Tr1 to Tr3 are in the OFF state.

It has to be noted here that the linear amplification state may be named also saturation state, the ON state may be named also ohmic state.

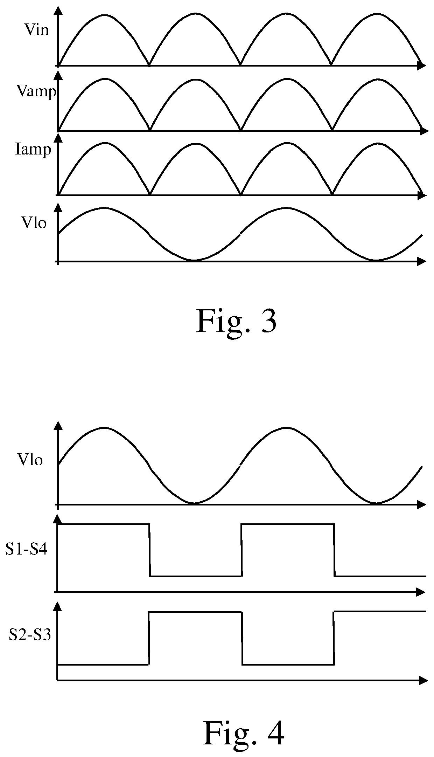

**Fig. 3** represents the different waveforms of signals of the asymmetric linear amplifier according to the present invention.

In Fig. 3, the signals Vin, Vamp, lamp and Vlo are shown.

The signal Vlo is the voltage on the load Lo.

**Fig. 4** represents the waveforms for controlling the semiconductors of the H bridge module of the linear amplifier.

In Fig. 4, the voltage Vlo, the command signal S1-S4 applied to the switches S1 and S4 and the command signal S2-S3 applied to the switches S2 and S3 are shown.

When the voltage Vlo is positive, the command signal S1-S4 is high and the switches S1 and S4 are conducting.

When the voltage Vlo is positive, the command signal S2-S4 is low and the switches S2 and S3 are not conducting.

When the voltage Vlo is negative, the command signal S1-S4 is low and the switches S1 and S4 are not conducting.

When the voltage Vlo is negative, the command signal S2-S4 is high and the switches S2 and S3 are conducting.

Naturally, many modifications can be made to the embodiments of the invention described above without departing from the scope of the present invention.

## Claims

1. A linear amplifier for providing a sinusoidal waveform to a load, **characterised in that** the linear amplifier is composed of an asymmetric amplifier and a H-bridge module, the asymmetric amplifier comprises at least one transistor that amplifies a full wave rectified sinus signal that is transformed by the H bridge module into a sinewave signal that is provided to the load.

2. The linear amplifier according to claim 1, **characterized in that** the asymmetric amplifier comprises plural transistors of the same type, and the same full wave rectified sinus signal is provided to each transistor.

3. The linear amplifier according to claim 2, **characterized in that** the transistors are N type semiconductors.

4. The linear amplifier according to claim 2 or 3, **characterized in that** each transistor is in a OFF state or in a linear amplification state or in a ON state and only one transistor among the plural transistors is in the linear amplification state during at least one period of time of the period of the full wave rectified sinus signal.

5. The linear amplifier according to claim 4, **characterized in that** the asymmetric amplifier comprises the same number of DC voltage sources as the number of transistors.

6. The linear amplifier according to claim 5, **characterized in that** each voltage source provides the same voltage value.
